# EUROPÄISCHE PATENTSCHRIFT

(11) **EP 3 787 040 B1**
(45) Veröffentlichungstag und Bekanntmachung des Hinweises auf die Patenterteilung: **30.09.2026**
(21) Anmeldenummer: 20000290.5
(22) Anmeldetag: 17.08.2020
(51) Int. Cl.: H10F 10/142, H10F 77/20

(54) **METALLISIERUNGSVERFAHREN FÜR EINE HALBLEITERSCHEIBE**
METHOD OF METALLIZING A SEMICONDUCTOR WAFER
PROCÉDÉ DE MÉTALLISATION POUR UNE TRANCHE SEMI-CONDUCTRICE

(30) Priorität: 29.08.2019 DE 102019006098; 02.03.2020 DE 102020001342
(43) Veröffentlichungstag der Anmeldung: 03.03.2021
(73) Patentinhaber: AZUR SPACE Solar Power GmbH, 74072 Heilbronn (DE)
(72) Erfinder: Köstler, Wolfgang, 74074 Heilbronn (DE); Hagedorn, Benjamin, 74248 Ellhofen (DE)
(74) Vertreter: Koch Müller Patentanwaltsgesellschaft mbH

(56) Entgegenhaltungen:
- EP-A2- 1 715 529
- WO-A1-2019/143776
- WO-A1-2020/014499
- WO-A1-89/05521
- US-A1- 2014 048 128
- US-A1- 2017 345 955
- "Flat Panel Display Manufacturing, First Edition", 6 August 2018, JOHN WILEY & SONS LTD, ISBN: 978-1-119-16134-9, article YASUNORI NISHIMURA ET AL: "Chapter 13 Photolithography", pages: 287 - 310, XP055752770, DOI: https://doi.org/10.1002/9781119161387.ch13

## Beschreibung

Die Erfindung betrifft ein Metallisierungsverfahren für eine Halbleiterscheibe.

Es sind unterschiedliche Verfahren zur Metallisierung von Halbleiterscheiben bekannt. Die gewünschte Metallstruktur wird beispielsweise mit Hilfe einer Lackmaske aus Positivlack oder aus Negativlack erzeugt, wobei das Metall flächig, z.B. mittels physikalischer Gasphasenabscheidung, aufgebracht wird. Alternativ werden Druckverfahren genutzt, z.B. Siebdruck oder Dispensköpfe, welche direkt nur die gewünschte Metallstruktur aufbringen.

Um die Abschattung der Vorderseite einer Solarzelle zu reduzieren, ist es möglich, die Vorderseite mittels einer Durchgangskontaktöffnung von der Rückseite zu kontaktieren. Solche Solarzellen werden auch als metal wrap through (MWT) - Solarzellen bezeichnet.

Neben unterschiedlichen Herstellungsverfahren der Durchgangskontaktöffnung sind auch unterschiedliche Metallisierungsverfahren bekannt, um insbesondere eine zuverlässige Metallisierung im Bereich der Durchgangskontaktöffnung zu erreichen.

Aus "Die Metal Wrap Through Solarzelle - Entwicklung und Charakterisierung", F. Clement, Dissertation, Februar 2009 ist Herstellungsverfahren für eine MWTeinfach-Solarzelle aus multikristallinem Silizium bekannt, wobei die Durchgangskontaktöffnungen mittels eines UV-Lasers oder eines IR-Lasers in einer mc Si-Substratschicht erzeugt werden.

Erst anschließend wird mittels Phosphordiffusion entlang der Oberseite, der Seitenflächen der Durchgangskontaktöffnung und der Unterseite der Solarzelle eine Emitterschicht erzeugt. Die Durchgangskontaktöffnung wird mit mittels Siebdrucks mit einer leitfähigen Via-Paste, z.B. einer Silberpaste, gefüllt.

Des Weiteren sind aus der WO 2019/143776 A1, der US 2017/345955 A1, der EP 1 715 529 A2, der US 2014/0481238 A1, der WO 89/05521 A1, und der WO 2020/014499 A1 (Art. 54(3) EPÜ) weitere Solarzellenanordnungen bekannt.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AlGaAs Solarzellenstruktur mit Durchgangskontaktöffnungen bekannt, wobei die Solarzellenstruktur mit den pn-Übergängen epitaktisch gewachsen und ersten anschließend die Durchgangskontaktöffnungen mittels Trockenätzen erzeugt wird. Eine Seitenfläche der Durchgangsöffnung wird anschließend mit einer Isolationsschicht beschichtet und die Durchgangsöffnung wird anschließend galvanisch mit Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt wird.

Der Ätzprozess basiert darauf, dass sich die Ätzraten zumindest für die verwendeten unterschiedlichen III-V-Materialien des Solarzellenstapels nicht Wesentlich unterschieden. Das Loch wird erst durch Dünnen der Substratschicht nach unten geöffnet. Eine Passivierung und Metallisierung der Vorderseite und des Lochs wird vor dem Dünnen der Substratschicht durchgeführt.

Vor diesem Hintergrund besteht die Aufgabe der Erfindung darin, eine Vorrichtung anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Metallisierungsverfahren für eine Halbleiterscheibe bereitgestellt, umfassend mindestens die Schritte:
- Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle und mindestens zwei III-V-Teilzellen in der genannten Reihenfolge sowie mindestens eine von der Oberseite bis zu der Unterseite der Halbleiterscheibe reichende Durchgangsöffnung mit zusammenhängender Seitenwand und einem im Querschnitt ovalen Umfang aufweist,
- gebietsweises Aufbringen einer Lackschicht als Lackmuster mittels eines Druckverfahrens auf der Oberseite oder auf der Unterseite der Halbleiterscheibe oder sowohl auf der Oberseite als auch der Unterseite der Halbleiterscheibe,
- flächiges Aufbringen einer Metallschicht auf freiliegende Bereiche der mit der Fotolackschicht beschichteten Oberfläche der Halbleiterscheibe sowie auf die Lackschicht,
- Ablösen des Lackmusters mit dem darauf befindlichen Teil der Metallschicht von der Halbleiterscheibe.

Es versteht sich, dass die einzelnen Teilzellen der Solarzellenstapel jeweils einen pn-Übergang aufweisen und die auf das Substrat folgenden Schichten epitaktisch aufeinander erzeugt und/oder mittels eines Wafer-Bond-Verfahrens miteinander verbunden sind.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bestehen.

Mittels des Druckverfahrens wird die Lackschicht besonders einfach, schnell, zuverlässig bzw. präzise und reproduzierbar aufgebracht. Insbesondere ermöglicht es das Verfahren, beispielsweise die Durchgangskontaktlöcher zuverlässig auszusparen.

Ein Vorteil des Verfahrens ist daher, dass mittels eines flächigen Aufbringens der Metallisierung gleichzeitig in einem Schritt sowohl ein zuverlässiges Metallisieren der Durchgangsöffnungen, also insbesondere der Seitenflächen der Durchgangsöffnung, sowie einer Oberfläche der Halbleiterscheibe, also der Oberseite und/oder der Unterseite, ermöglicht.

Das Metallisierungsverfahren ist daher besonders kostengünstig und zuverlässig.

Je zusammenhängender das Lackmuster ausgebildet ist, d.h. aus je weniger einzelnen, nicht miteinander verbundenen Abschnitten das Lackmuster besteht, umso einfacher und schneller gestaltet sich der Ablösevorgang.

In einer Weiterbildung wird nach dem Aufbringen der Fotolackschicht und vor dem Aufbringen der Metallschicht die Fotolackschicht mittels eines photolithographischen Verfahrens feinstrukturiert.

Anders ausgedrückt, nach einer Grobstrukturierung, also dem bereichsweise Aufbringen der Fotolackschicht mittels des Druckverfahrens, wird vor dem Aufbringen der Metallschicht mittels eines photolithographischen Verfahrens eine zweite Strukturierung, d.h. eine Feinstrukturierung durchgeführt. Hierbei lassen sich auch feine Strukturen in einem Bereich von wenigen µm zuverlässig und reproduzierbar herstellen. Es versteht sich, dass es sich bei dem Lack um einen photostrukturierbaren Lack handelt.

In einer Ausführungsform ist die Fotolackschicht als Negativlackschicht oder als Positivlackschicht ausgebildet, wobei das Lackmuster jeweils als ein Inverses eines Leiterbahnplans ausgebildet wird.

In einer anderen Ausführungsform spart die Lackschicht die Durchgangsöffnungen aus. Hierdurch wird eine zuverlässige Beschichtung der Seitenflächen der Durchgangsöffnungen während der anschließenden Metallisierung sichergestellt.

Gemäß einer anderen Weiterbildung weist die bereitgestellte Halbleiterscheibe Trenngräben auf, wobei die Lackschicht auf eine Oberfläche der Trenngräben aufgebracht wird.

In einer weiteren Weiterbildung ist das Druckverfahren ein Inkjet-Verfahren. Es hat sich gezeigt, dass ein Lackmuster mittels eines Inkjet-Verfahrens besonders zuverlässig und präzise erzeugt werden kann.

In einer anderen Ausführungsform weisen die Durchgangsöffnungen der bereitgestellten Halbleiterscheibe an einem an die Oberseite der Halbleiterscheibe angrenzenden Rand einen ersten Durchmesser von höchstens 1 mm und mindestens 300 µm oder mindestens 400 µm oder mindestens 450 µm auf.

An einem an die Unterseite der Halbleiterscheibe angrenzenden Rand weisen die Durchgangsöffnungen einen zweiten Durchmesser von höchstens 500 µm und von mindestens 50 µm oder mindestens 100 µm auf.

Vorzugsweise weist die bereitgestellte Halbleiterscheibe eine Gesamtdicke von höchstens 300 µm und von mindestens 90 µm oder von mindestens 150 µm oder von mindestens 200 µm auf.

Gemäß einer weiteren Ausführungsform weist das Lackmuster mindestens einen an einen Rand der Halbleiterscheibe reichenden Hilfsabschnitt wobei das Ablösen der Lackschicht mit dem Hilfsabschnitt begonnen wird.

In einer weiteren ist das Lackmuster auf der Unterseite der Halbleiterscheibe und/oder auf der Oberseite der Halbleiterscheibe jeweils zumindest im Bereich jedes einzelnen Solarzellenstapels oder über mehrere Solarzellenstapel hinweg oder über die gesamte Unterseite der Halbleiterscheibe hinweg zusammenhängend ausgebildet.

Gemäß einer anderen Ausführungsform weist die bereitgestellte Halbleiterscheibe eine die Seitenwand der Durchgangsöffnung sowie einen an die Durchgangsöffnung angrenzenden Bereich der Oberseite der Halbleiterscheibe und einen an die Durchgangsöffnung angrenzenden Bereich der Unterseite der Halbleiterscheibe bedeckende dielektrische Isolationsschicht auf.

In einer weiteren Ausführungsform wird das Verfahren zuerst für die Unterseite und dann für die Oberseite der Halbleiterscheibe durchgeführt. Es wird also zuerst Unterseite der Halbleiterscheibe gemäß dem Verfahren metallisiert.

Erst nachdem das Verfahren, d.h. die Prozesse Belacken, Metall aufbringen und Abziehen der Lackschicht, vollständig für die Unterseite durchgeführt wurde, wird das Verfahren auf die Oberseite derselben Halbleiterscheibe angewandt.

Alternativ wird die Metallisierung der Oberseite mit von dem Verfahren abweichenden Verfahrensschritten Metallisiert.

Wiederum alternativ wird das Verfahren immer abwechselnd für die Oberseite und die Unterseite der Halbleiterscheibe durchgeführt, d.h. jeder Verfahrensschritt zuerst für die Ober- dann für die Unterseite oder vice versa, ehe der darauffolgende Verfahrensschritt entsprechend folgt.

Ebenso alternativ wird das Verfahren erst vollständig auf die Oberseite der Halbleiterscheibe und anschließend auf die Unterseite der Halbleiterscheibe angewandt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Aufsicht auf eine Halbleiterscheibe,
- Figur 2: eine Rückseitenansicht eines gemäß dem Metallisierungsverfahren metallisierten Solarzellenstapelrückseite,
- Figur 3: einen Ablauf gemäß einer ersten erfindungsgemäßen Ausführungsform des Metallisierungsverfahrens,
- Figur 4: einen Querschnitt einer Durchgangsöffnung einer Halbleiterscheibe nach dem Aufbringen der Fotolackschicht auf Oberseite und Unterseite,
- Figur 5: einen Querschnitt einer Durchgangsöffnung einer Halbleiterscheibe nach dem Ablösen der Fotolackschicht von der Oberseite und der Unterseite,
- Figur 6: einen Querschnitt einer Durchgangsöffnung einer Halbleiterscheibe nach dem Aufbringen der Fotolackschicht auf der Unterseite,
- Figur 7: einen Querschnitt einer Durchgangsöffnung einer Halbleiterscheibe nach dem Ablösen der Fotolackschicht von der Unterseite.

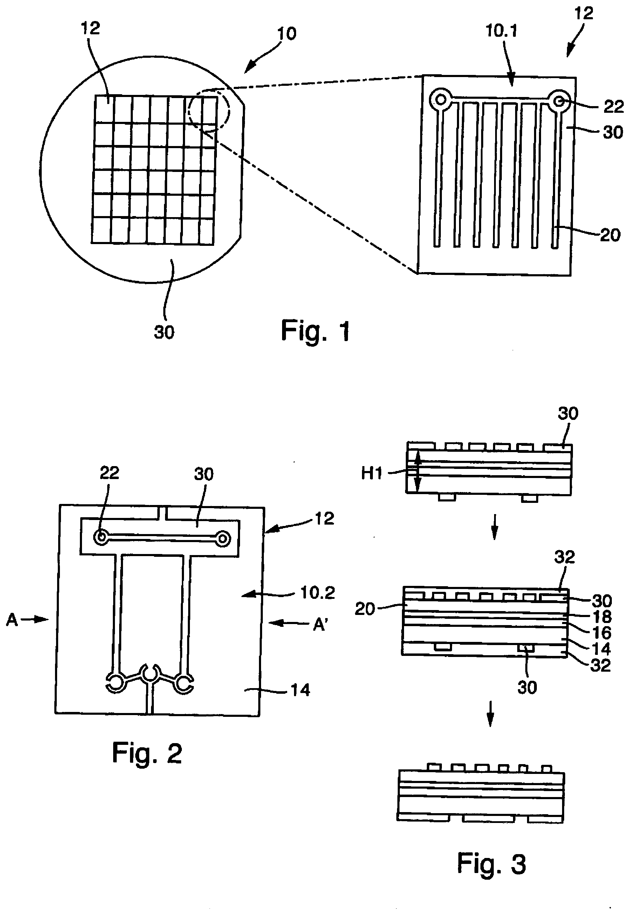

Die Abbildungen der Figuren 1 und 2 zeigen eine Aufsicht und einen Rückseitenausschnitt einer Halbleiterscheibe 10 mit einer gemäß dem Verfahren aufgebrachten Fotolackschicht 30.

Die Halbleiterscheibe 10 weist eine Oberseite 10.1, eine Unterseite 10.2 und mehrere Solarzellenstapel 12 auf, wobei jeder Solarzellenstapel 12 ein die Unterseite 10.1 ausbildendes Ge-Substrat 14, eine Ge-Teilzelle 16, eine erste III-V-Teilzelle 18 und eine die Oberseite 10.1 ausbildende zweiten III-V-Teilzelle 20 aufweist.

Jeder Solarzellenstapel 12 weist außerdem zwei von der Oberseite 10.1 bis zu der Unterseite 10.2 reichende Durchgangsöffnungen 22 auf.

Auf der Oberseite 10.1 der Halbleiterscheibe 10, hier also jeweils auf der zweiten III-V-Teilzelle 20, ist eine Fotolackschicht 30 als Lackmuster aufgebracht, wobei das Lackmuster jeweils einen Bereich um die Durchgangsöffnungen 22 sowie mehrere linienförmige Bereiche für Kontaktfinger und eine die Durchgangsöffnungen 22 und die Kontaktfinger verbindende Sammelschiene pro Solarzellenstapel 12 ausspart.

Hierbei reicht die Fotolackschicht 30 jeweils flächig bis an die Ränder jedes Solarzellenstapels und ist über alle Solarzellenstapel 12 der Halbleiterscheibe 10 hinweg verbunden.

Die Fotolackschicht 30, also das Lackmuster, erstreckt sich außerdem flächig bis zu einem Rand der Halbleiterscheibe 10, so dass die gesamte Fotolackschicht 30 zusammenhängend von der Oberseite 10.1 der Halbleiterscheibe 10 über die einzelnen Solarzellenstapel hinweg wieder ablösen lässt.

Auf der Rückseite 10.2 der Halbleiterscheibe, also dem Ge-Substrat 14, weist das Lackmuster der Fotolackschicht 30 pro Solarzellenstapel einen die Durchgangslöcher umgebenden Bereich sowie bis an den Rand des einzelnen Solarzellenstapels reichende Verbindungsstege auf. Anders ausgedrückt die Durchgangslöcher werden ausgespart.

Die Verbindungsstege benachbarte Solarzellenstapel sind miteinander verbunden, so dass das Lackmuster zumindest entlang jeder Reihe von Solarzellenstapel eine zusammenhängende Struktur aufweist und hierdurch zusammenhängend wieder ablösen lässt.

In einer nicht dargestellten Weiterbildung sind die Verbindungstege am Ende einer Reihe von Solarzellenstapeln mit einer bis zu dem Rand der Halbleiterscheibe reichenden Hilfsabschnitt verbunden, so dass sie vom Rand her leichter abgelöst werden können.

In der Abbildung der Figur 3 ist ein Ablauf eines Metallisierungsverfahrens für eine Halbleiterscheibe 10 gemäß einer ersten erfindungsgemäßen Ausführungsform dargestellt. Die einzelnen Verfahrensschritte werden jeweils sowohl auf die Oberseite als auch auf die Unterseite der Halbleiterscheibe angewandt.

Die Halbleiterscheibe 10 mit einer Gesamtschichtdicke H1 wird bereitgestellt.

Auf der Oberseite 10.1 sowie auf der Unterseite 10.2 der Halbleiterscheibe 10 wird mittels eines Druckverfahrens eine Fotolackschicht 30 als Lackmuster aufgebracht. Die Fotolackschicht 30 wird also nur gebietsweise aufgebracht.

Anschließend wird auf die Oberseite 10.1 sowie auf die Unterseite 10.2 der Halbleiterscheibe 10 eine Metallschicht 32 flächig aufgebracht.

Die Metallschicht 32 bedeckt somit sowohl die Fotolackschicht 30 als auch die nicht von der Fotolackschicht 30 bedeckten, sondern freiliegenden Bereiche der Oberseite 10.1 bzw. der Unterseite 10.2 der Halbleiterscheibe 10.

In einem folgenden Verfahrensschritt wird die Fotolackschicht 30 zusammen mit dem auf der Fotolackschicht 30 befindlichen Teil der Metallschicht 32 abgelöst. Auf der Oberseite 10.1 und der Unterseite 10.2 der Halbleiterscheibe 10 verbleibt jeweils eine Reststruktur der Metallschicht 32, wobei die Reststruktur ein Negativ des Lackmusters ist.

Alternativ und hier nicht ausdrücklich dargestellt werden die Verfahrensschritte nur auf die Oberseite oder nur auf die Unterseite angewandt und die jeweilig andere Oberfläche der Halbleiterscheibe bleibt entsprechend unverändert. Gemäß einer anderen, hier ebenfalls nicht dargestellten alternativen Ausführungsform wird das Verfahren zuerst vollständig für eine der Oberflächen der Halbleiterscheibe, also für die Unterseite oder für die Oberseite, durchgeführt, während die andere Oberfläche unverändert bleibt. Anschließend wird das Verfahren auf die noch unveränderte Oberfläche angewandt.

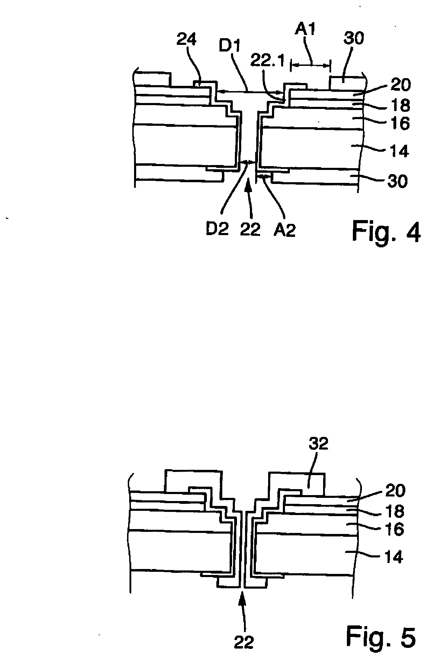

In der Abbildung der Figur 4 ist ein Querschnitt einer Durchgangsöffnung 22 einer Halbleiterscheibe 10 nach dem Aufbringen der Fotolackschicht 30 dargestellt. Im Folgenden werden nur die Unterschiede zu der Abbildung der Figur 3 erläutert.

Die Durchgangsöffnung 22 weist eine zusammenhängende Seitenwand 22.1 und einen im Querschnitt ovalen Umfang, einen ersten Durchmesser D1 an der Oberseite 10.1 der Halbleiterscheibe 10 und einen zweiten Durchmesser D2 an der Unterseite 10.2 der Halbleiterscheibe 10 auf.

Die Seitenwand 22.1 der Durchgangsöffnung 22 sowie ein an die Durchgangsöffnung 22 angrenzender Bereich der Oberseite 10.1 und ein an die Durchgangsöffnung 22 angrenzender Bereich der Unterseite 10.1 der Halbleiterscheibe 10 sind mit einer dielektrischen Isolationsschicht 24 beschichtet.

Die Fotolackschicht 30 auf der Oberseite 10.1 weist einen Abstand A1 zu einem Rand der Durchgangsöffnung 22 und auf der Unterseite 10.2 einen Abstand A2 zu einem Rand der Durchgangsöffnung 22 auf.

Hierbei ist der Abstand A1 so groß, dass die Fotolackschicht 30 auf der Oberseite 10.1 der Halbleiterscheibe 10 zu der dielektrischen Isolationsschicht 24 beabstandet ist. Anders ausgedrückt die Durchgangslöcher werden bei dem Aufbringen von der Fotolackschicht 30 ausgespart.

Der Abstand A2 ist kleiner als der Abstand A1 und so gewählt, dass sich die Fotolackschicht 30 auf der Unterseite 10.1 der Halbleiterscheibe 10 auch über einen Randbereich der dielektrischen Isolationsschicht 24 erstreckt.

In der Abbildung der Figur 5 ist ein Querschnitt einer Durchgangsöffnung 22 einer Halbleiterscheibe 10 nach dem Aufbringen der Metallschicht 32 und nach dem Ablösen der Fotolackschicht 30, also des Lackmusters, dargestellt. Im Folgenden werden nur die Unterschiede zu der Abbildung der Figur 4 erläutert.

Die nach dem Ablösen des Lackmusters verbliebene Metallschicht 32 erstreckt sich über die Seitenwand 22.1 der Durchgangsöffnung 22 sowie über einen Teil der dielektrischen Isolationsschicht 24 auf der Unterseite 10.2 der Halbleiterscheibe 10. Die Metallschicht 32 ist also zu der freiliegenden, nicht isolierten Oberfläche der Unterseite 10.2 der Halbleiterscheibe beabstandet.

Auf der Oberseite 10.2 reicht die Metallschicht 32 über die dielektrische Isolationsschicht 24 bis auf einen an die dielektrische Isolationsschicht 24 angrenzenden freiliegenden Bereich der Oberseite 10.1 der Halbleiterscheibe. Die Metallschicht 32 ist also sowohl mit der dielektrischen Isolationsschicht 24 als auch mit einem freiliegenden Oberflächenbereich der Halbleiterscheibe, hier der zweiten III-V-Teilzelle 20 stoffschlüssig verbunden.

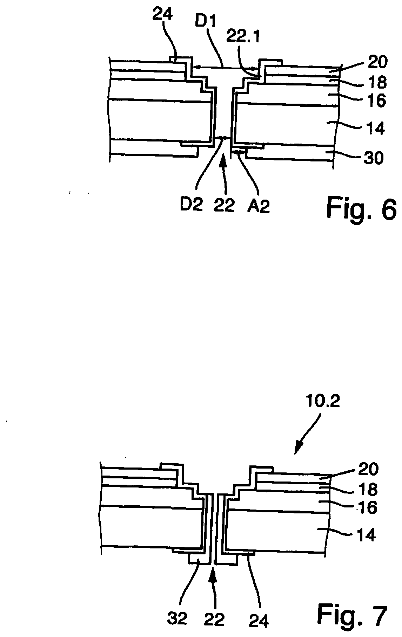

In den Abbildungen der Figuren 6 und 7 ist eine weitere Ausführungsform des erfindungsgemäßen Verfahrens dargestellt, wobei im Folgenden nur die Unterschiede zu den Figuren 3 bis 6 erläutert werden.

Das Verfahren wird auf die Unterseite 10.1 der Halbleiterscheibe angewandt. In der Figur 6 ist ein Querschnitt einer der Durchgangsöffnungen 22 der Halbleiterscheibe 10 nach dem Aufbringen der Fotolackschicht 30 auf der Unterseite dargestellt, während die Oberseite 10.2 unverändert, also insbesondere ohne Fotolackschicht 30 verbleibt.

In der Abbildung der Figur 7 ist ein Querschnitt der Durchgangsöffnung 22 der Halbleiterscheibe 10 nach dem Aufbringen der Metallschicht 32 auf der Unterseite 10.2 und dem Ablösen der Fotolackschicht 30 von der Unterseite 10.2, also des Lackmusters, dargestellt. Die verbliebene Metallschicht 32 bedeckt einen Teil der Unterseite 10.2, insbesondere einen von der Isolationsschicht 24 ausgebildeten Bereich um die Durchgangsöffnung 22 und einen an die Unterseite 10.2 angrenzenden Bereich der Seitenwand 22.1 der Durchgangsöffnung. Die Oberseite 10.1 der Halbleiterscheibe sowie ein sich an die Oberseite 10.1 anschließender Bereich der Seitenwand 22.1 der Durchgangsöffnung 22 ist nicht von der Metallschicht 32 bedeckt.

## Patentansprüche

1. Metallisierungsverfahren für eine Halbleiterscheibe (10) umfassend mindestens die Schritte:
- Bereitstellen einer Halbleiterscheibe (10) mit einer Oberseite (10.1), einer Unterseite (10.2) und umfassend mehrere Solarzellenstapel (12),
- wobei jeder Solarzellenstapel (12) ein die Unterseite (10.1) der Halbleiterscheibe ausbildendes Ge-Substrat (14), eine Ge-Teilzelle (16) und mindestens zwei III-V-Teilzellen (18, 20) in der genannten Reihenfolge sowie mindestens eine von der Oberseite (10.1) bis zu der Unterseite (10.2) der Halbleiterscheibe (10) reichende Durchgangsöffnung (22) mit zusammenhängender Seitenwand (22.1) und einem im Querschnitt ovalen Umfang aufweist, wobei die Durchgangsöffnung (22) an der Oberseite (10.1) eine größeren Durchmesser als an der Unterseite (10.2) aufweist
- gebietsweises Aufbringen einer Fotolackschicht (30) als Lackmuster mittels eines Druckverfahrens auf der Oberseite (10.1) oder auf der Unterseite (10.2) oder auf der Ober- und Unterseite (10.1, 10.2) der Halbleiterscheibe (10),
- flächiges Aufbringen einer Metallschicht (32) auf freiliegende Bereiche der mit dem Fotolackschicht (30) beschichteten Oberfläche der Halbleiterscheibe (10) sowie auf die Fotolackschicht (30),
- Ablösen des Lackmusters mit dem darauf befindlichen Teil der Metallschicht (32) von der Halbleiterscheibe (10).

2. Verfahren nach Anspruch 1, **dadurch gekennzeichnet, dass** nach dem Aufbringen der Fotolackschicht (30) und vor dem Aufbringen der Metallschicht (32) die Fotolackschicht (30) mittels eines photolithographischen Verfahrens feinstrukturiert wird.

3. Verfahren nach Anspruch 1 oder 2, **dadurch gekennzeichnet, dass** die Fotolackschicht (30) als Negativlackschicht oder als Positivlackschicht ausgebildet ist, wobei das Lackmuster jeweils als ein Inverses eines Leiterbahnplans ausgebildet wird.

4. Verfahren nach einem der vorstehenden Ansprüche, **dadurch gekennzeichnet, dass** die Lackschicht die Durchgangsöffnungen (22) ausspart.

5. Verfahren nach einem der vorstehenden Ansprüche, **dadurch gekennzeichnet, dass** das Druckverfahren ein Inkjet-Verfahren ist.

6. Verfahren nach einem der vorstehenden Ansprüche, **dadurch gekennzeichnet, dass** die Durchgangsöffnungen (22) der bereitgestellten Halbleiterscheibe
- an einem an die Oberseite (10.1) der Halbleiterscheibe (10) angrenzenden Rand einen ersten Durchmesser (D1) von höchstens 1 mm und mindestens 300 µm oder mindestens 400 µm oder mindestens 450 µm aufweisen und
- an einem an die Unterseite (10.2) der Halbleiterscheibe (10) angrenzenden Rand einen zweiten Durchmesser (D2) von höchstens 500 µm und von mindestens 50 µm oder mindestens 100 µm aufweist, wobei
- die bereitgestellte Halbleiterscheibe (10) eine Gesamtdicke (H1) von höchstens 300 µm und von mindestens 90 µm oder von mindestens 150 µm oder von mindestens 200 µm aufweisen.

7. Verfahren nach einem der vorstehenden Ansprüche, **dadurch gekennzeichnet, dass** das Lackmuster mindestens einen an einen Rand der Halbleiterscheibe reichenden Hilfsabschnitt aufweist, wobei das Ablösen der Lackschicht (30) mit dem Hilfsabschnitt begonnen wird.

8. Verfahren nach einem der vorstehenden Ansprüche, **dadurch gekennzeichnet, dass** das Lackmuster auf der Unterseite (10.2) und/oder der Oberseite (10.1) der Halbleiterscheibe (10) jeweils zumindest im Bereich jedes einzelnen Solarzellenstapels (12) oder über mehrere Solarzellenstapel (12) hinweg oder über die gesamte Unterseite (10.2) und/oder Oberseite (10.1) der Halbleiterscheibe (10) hinweg zusammenhängend ausgebildet ist.

9. Verfahren nach einem der vorstehenden Ansprüche, **dadurch gekennzeichnet, dass** die Fotolackschicht (30) vor dem Aufbringen der Metallschicht (32) mittels eines photolithographischen Verfahrens feinstrukturiert wird.

10. Verfahren nach einem der vorstehenden Ansprüche, **dadurch gekennzeichnet, dass** die bereitgestellte Halbleiterscheibe (10) eine die Seitenwand (22.1) der Durchgangsöffnung (22) sowie einen an die Durchgangsöffnung (22) angrenzenden Bereich der Oberseite (10.1) der Halbleiterscheibe (10) und einen an die Durchgangsöffnung (22) angrenzenden Bereich der Unterseite (10.2) der Halbleiterscheibe (10) bedeckende dielektrische Isolationsschicht (24) aufweist.

11. Verfahren nach einem der vorstehenden Ansprüche, **dadurch gekennzeichnet, dass** das Verfahren zuerst für die Unterseite (10.2) und anschließend für die Oberseite (10.1) der Halbleiterscheibe (10) durchgeführt wird.

12. Verfahren nach Anspruch 1, **dadurch gekennzeichnet, dass** das gebietsweise Aufbringen der Fotolackschicht (30) unter Aussparung der Durchgangsöffnung (22) durchgeführt wird.

## Claims

1. Metallisation method for a semiconductor wafer (10), comprising at least the steps of:
- providing a semiconductor wafer (10) with an upper side (10.1), a lower side (10.2) and comprising a plurality of solar cell stacks (12),
- wherein each solar cell stack (12) has a Ge substrate (14) forming the lower side (10.1) of the semiconductor wafer, a Ge sub-cell (16) and at least two III-V sub-cells (18, 20) in the stated sequence as well as at least one passage opening (22), which reaches from the upper side (10.1) to the lower side (10.2) of the semiconductor wafer (10), with continuous side walls (22.1) and a circumference oval in cross-section, wherein the passage opening (22) has a larger diameter at the upper side (10.1) than at the lower side (10.2),
- regionally applying a photoresist layer (30 as resist pattern by means of a printing method to the upper side (10.1) or to the lower side (10.2) or to the upper and lower sides (10.1, 10.2) of the semiconductor wafer (10),
- area application of a metal layer (32) to exposed regions of the surface, which is coated with the photoresist layer (30), of the semiconductor wafer (10) and to the photoresist layer (30) and
- detaching from the semiconductor wafer (10) the resist pattern with the part of the metal layer (32) disposed thereon.

2. Method according to claim 1, **characterised in that** after application of the photoresist layer (30) and before application of the metal layer 32) the photoresist layer (30) is finely structured by means of a photolithographic method.

3. Method according to claim 1 or 2, **characterised in that** the photoresist layer (30) is formed as a negative resist layer or as a positive resist layer, wherein the resist pattern is formed in each instance as an inverse of a conductor track layout.

4. Method according to any one of the preceding claims, **characterised in that** the resist layer leaves out the passage openings (22).

5. Method according to any one of the preceding claims, **characterised in that** the printing method is an inkjet method.

6. Method according to any one of the preceding claims, **characterised in that** the passage openings (22) of the provided semiconductor wafer have
- a first diameter (D1) of at most 1 mm and at least 300 µm or at least 400 µm or at least 450 µm at an edge adjoining the upper side (10.1) of the semiconductor wafer (10) and
- a second diameter (D2) of most 500 µm and at least 50 µm or at least 100 µm at an edge adjoining the lower side (10.2) of the semiconductor wafer (10), wherein
- the provided semiconductor wafer (10) has an overall thickness (H1) of at most 300 µm and at least 90 µm or at least 150 µm or at least 200 µm.

7. Method according to any one of the preceding claims, **characterised in that** the resist pattern has at least one assist section extending to an edge of the semiconductor wafer, wherein the detaching of the resist layer (30) begins with the assist section.

8. Method according to any one of the preceding claims, **characterised in that** the resist pattern is formed to be continuous on lower side (10.2) and/or the upper side (10.1) of the semiconductor wafer (10) in each instance at least in the region of each individual solar cell stack (12) or over several solar cell stacks (12) or over the entire lower side (10.2) and/or upper side (10.1) of the semiconductor wafer (10).

9. Method according to any one of the preceding claims, **characterised in that** the photoresist layer (30) is finely structured by means of a photolithographic method before application of the metal layer (32).

10. Method according to any one of the preceding claims, **characterised in that** the provided semiconductor wafer (10) has dielectric insulation layer (24) covering the side wall (22.1) of the passage opening (22) as well as a region, which adjoins the passage opening (22), of the upper side (10.1) of the semiconductor wafer (10) and a region, which adjoins the passage opening (22), of the lower side (10.2) of the semiconductor wafer (10).

11. Method according to any one of the preceding claims, **characterised in that** the method is carried out firstly for the lower side (10.2) and subsequently for the upper side (10.1) of the semiconductor wafer (10).

12. Method according to claim 1, **characterised in that** the regional application of the photoresist layer (30) is carried out with omission of the passage opening (22).

## Revendications

1. Procédé de métallisation pour une tranche semi-conductrice (10) comprenant au moins les étapes suivantes :
- fournir une tranche semi-conductrice (10) avec une face supérieure (10.1), une face inférieure (10.2) et comprenant plusieurs empilements de cellules solaires (12),
- chaque empilement de cellules solaires (12) comprenant un substrat Ge (14) formant la face inférieure (10.1) de la tranche semi-conductrice, une sous-cellule Ge (16) et au moins deux sous-cellules III-V (18, 20) dans l'ordre mentionné, ainsi qu'au moins une ouverture traversante (22) s'étendant de la face supérieure (10.1) à la face inférieure (10.2) de la tranche semi-conductrice (10), avec une paroi latérale (22.1) de manière continue et une circonférence ovale en coupe transversale, l'ouverture traversante (22) présentant un diamètre plus grand sur la face supérieure (10.1) que sur la face inférieure (10.2),
- application de manière localisée d'une couche de photorésine (30) comme motif de vernis au moyen d'un procédé d'impression sur la face supérieure (10.1) ou sur la face inférieure (10.2) ou sur les faces supérieure et inférieure (10.1, 10.2) de la tranche semi-conductrice (10),
- application de manière surfacique d'une couche métallique (32) sur les zones exposées de la surface de la tranche semi-conductrice (10) revêtue de la couche de photorésine (30) ainsi que sur la couche de photorésine (30),
- détacher le motif de vernis avec la partie correspondante de la couche métallique (32) de la tranche semi-conductrice (10).

2. Procédé selon la revendication 1, **caractérisé en ce qu'**après l'application de la couche de photorésine (30) et avant l'application de la couche métallique (32), la couche de photorésine (30) est structurée finement au moyen d'un procédé photolithographique.

3. Procédé selon la revendication 1 ou 2, **caractérisé en ce que** la couche de photorésine (30) est formée comme couche de vernis négatif ou comme couche de vernis positif, le motif de vernis étant dans chaque cas formé comme un inverse d'un schéma de pistes conductrices.

4. Procédé selon l'une des revendications précédentes, **caractérisé en ce que** la couche de vernis ménage les ouvertures traversantes (22).

5. Procédé selon l'une des revendications précédentes, **caractérisé en ce que** le procédé d'impression est un procédé à jet d'encre.

6. Procédé selon l'une des revendications précédentes, **caractérisé en ce que** les ouvertures traversantes (22) de la tranche semi-conductrice fournie
- présentent, sur un bord adjacent à la face supérieure (10.1) de la tranche semi-conductrice (10), un premier diamètre (D1) d'au plus 1 mm et d'au moins 300 µm ou d'au moins 400 µm ou d'au moins 450 µm, et
- présentent, sur un bord adjacent à la face inférieure (10.2) de la tranche semi-conductrice (10), un second diamètre (D2) d'au plus 500 µm et d'au moins 50 µm ou d'au moins 100 µm, où
- la tranche semi-conductrice (10) fournie présente une épaisseur totale (H1) d'au plus 300 µm et d'au moins 90 µm ou d'au moins 150 µm ou d'au moins 200 µm.

7. Procédé selon l'une des revendications précédentes, **caractérisé en ce que** le motif de vernis présente au moins une section auxiliaire atteignant un bord de la tranche semi-conductrice, le détachement de la couche de vernis (30) commençant par la section auxiliaire.

8. Procédé selon l'une des revendications précédentes, **caractérisé en ce que** le motif de vernis sur la face inférieure (10.2) et/ou la face supérieure (10.1) de la tranche semi-conductrice (10) est formé de manière continue au moins dans la zone de chaque empilement de cellules solaires (12) ou sur plusieurs empilements de cellules solaires (12) ou sur l'ensemble de la face inférieure (10.2) et/ou de la face supérieure (10.1) de la tranche semi-conductrice (10).

9. Procédé selon l'une des revendications précédentes, **caractérisé en ce que** la couche de photorésine (30) est structurée finement au moyen d'un procédé photolithographique avant l'application de la couche métallique (32).

10. Procédé selon l'une des revendications précédentes, **caractérisé en ce que** la tranche semi-conductrice (10) fournie comprend une couche d'isolation diélectrique (24) recouvrant la paroi latérale (22.1) de l'ouverture traversante (22) ainsi qu'une zone de la face supérieure (10.1) de la tranche semi-conductrice (10) adjacente à l'ouverture traversante (22) et une zone de la face inférieure (10.2) de la tranche semi-conductrice (10) adjacente à l'ouverture traversante (22).

11. Procédé selon l'une des revendications précédentes, **caractérisé en ce que** le procédé est effectué d'abord pour la face inférieure (10.2) puis pour la face supérieure (10.1) de la tranche semi-conductrice (10).

12. Procédé selon la revendication 1, **caractérisé en ce que** l'application de manière localisée de la couche de photorésine (30) est effectuée en ménageant l'ouverture traversante (22).
